**Europäisches Patentamt**

(19) **European Patent Office**

**Office européen des brevets**

(11) Publication number: **0 101 630**
**B1**

(12) **EUROPEAN PATENT SPECIFICATION**

(45) Date of publication of patent specification: **29.04.87**

(21) Application number: **83201115.9**

(22) Date of filing: **27.07.83**

(51) Int. Cl.⁴: **H 01 L 21/56**

(54) Method and system for encapsulating electronic components into plastic material.

�úmero Priority: **19.08.82 NL 8203253**

(43) Date of publication of application:
**29.02.84 Bulletin 84/09**

(45) Publication of the grant of the patent:
**29.04.87 Bulletin 87/18**

(84) Designated Contracting States:
**AT BE CH DE FR GB IT LI LU NL SE**

(56) References cited:
**EP-A-0 007 762**
**FR-A-2 390 008**

(73) Proprietor: **ARBO HANDELS- EN
ONTWIKKELINGSMIJ B.V.
Edisonstraat 96 P.O. Box 172
NL-6900 AD Zevenaar (NL)**

(72) Inventor: **Boschman, Everardus Hendrikus
Kerkweg 35
NL-6913 AJ Aerdt Gld. (NL)**

(74) Representative: **van der Beek, George Frans
et al
Nederlandsch Octrooibureau Johan de Wittlaan
15 P.O. Box 29720
NL-2502 LS 's-Gravenhage (NL)**

## Description

The invention relates to a method for encapsulating electronic components in a plastic material, which components are mounted in elements, which elements form a part of a lead frame or lead frames, which are placed according to one or more parallel rows in a mould, comprising a lower and upper mould member which members can be moved against each other and away from each other and each are provided with a row or a plurality of parallel rows of mould cavities, which in the closed position of the mould form the spaces into which the plastic material has to be injected to encapsulate the electronic components present therein and which in number are equal to the number of elements, which mould cavities are connected with sprue channels in at least one of the opposite faces of the mould members.

Such a method is known from EP—A 0 007 762. According to said known method lead frames are placed parallel to each other in a mould which mould has been provided with a great number of sprue channels with main and side branches and connected to a central press cylinder by means of which the plastic material can be pressed into the many mould cavities to encapsulate the components present therein. According to said known method the lead frames are placed into the opened mould by hand. Removal also has to be done by hand and is difficult because of the great length of the sprues present in the grid of sprue channels and due to the fact that part of the sprues extend into the vertical bore of the press cylinder and accordingly stick inside one member of the mould.

Long sprue channels require a large amount of plastic material that forms waste material. Disconnecting the lead frames with encapsulated components from the grid of sprues is difficult and has to be done manually. Said long sprue channels also lead to the disadvantage that after opening the moulds frequently have to be cleaned.

It is the object of the invention to avoid the above-mentioned disadvantages and to make automation possible.

According to the invention this object is achieved in that the lead frame or lead frames have a length which is a multiplicity of the length of a row of elements fitting into a row of mould cavities of the mould, which lead frame or frames are step by step treated in said mould such that each time the encapsulation of a row of components of a row of elements present in the mould is completed, the lead frame or frames are moved in their longitudinal direction over a distance corresponding to the length of a lead frame that fits inside the mould, and that the supply of plastic material to the sprue channels and the therewith connected mould cavities in the closed position of the mould takes place from a side edge or the side edges of the mould which extend parallel to the row or rows of cavities.

Due to the fact that according to the invention the supply takes place from the sides of the mould no sprue channel extends through a member of the mould in vertical direction. Moreover the sprue channels can have a short length. After opening of the mould a treated lead frame can be easily removed in its longitudinal direction and a new lead frame can be supplied in the same line of movement so that according to the invention the lead frame now can have the form of a very long strip which somewhere in front of the mould has been provided with the components whilst behind the mould cleaning of the lead frame, e.g. by removal of the short sprues, can take place. This opens the possibility to an automatic process in which the long strip of lead frames is fed through the mould step by step intact with the operation of the mould.

The invention also deals with a system for encapsulating electronic components in a plastic material, comprising a mould with upper and lower mould members, which can be moved apart or upon each other and other and which each are provided with a row or with parallel rows of complementary mould cavities, which each are connected with a sprue channel in at least one of the opposite cooperating faces of the mould members, which sprue channels are connected to a supply of plastic material, the mutual distance between the mould cavities of each row being such that a lead frame or lead frames of elements with components can be placed in said mould for simultaneous encapsulation of all components of the lead frame or frames. This system known as well from EP—A 0 007 762, is improved according to the invention in that all sprue channels extend towards the side edge or side edges of the mould which extend parallel to the row or rows of cavities and at said side edge or edges are connected to a plastic supply device located at the said side edge or edges and in that it includes means for step by step transporting a lead frame strip between the upper and lower mould members.

This means that the sprue channels are short, extend only in those surfaces or surface of the mould members between a mould cavity and a side edge of the mould and this facilitates placing and removal respectively of the lead frames because there are no vertical parts of the sprues that stick to a mould member and prevent removal. Moreover the loss of plastic material is considerably reduced and cleaning hardly has to take place in particular not if moulds are used of the type described in the copending European application 83201116.7 (EP—A—101631) which mould is a hardened surface layer which facilitates the removal and makes the use of release pins superfluous.

It is observed that from FR—A—2 390 008 a method is known for the encapsulation of electronic components mounted on a lead frame by surrounding each component with prefabricated caps which, when placed on either side of the lead frame at the location of a component form a cavity into which the plastic material can be injected. Said caps remain as part of the encapsulation. This known method can be performed automatically and allows the step by step movement of a long lead frame and there is no loss of material due to sprues. On the other hand prefabricated caps are necessary as well as means or hands to place said caps on the lead frames and to properly interconnect them and connect them with the lead frames. The prefabricated caps require a separate device and in fact form by themselves a loss of material.

According to the invention each mould cavity can have its own plastic supplying device. This forms a further reduction of the length of the sprues and allows for proper control of the injection. It is possible as well, however, to use e.g. a common supply cylinder for two cavities in which case the sprues still are short.

According to the invention each supply device may have a press cylinder with a loading chamber, which in the retracted position of the press piston of said cylinder offers space to a plastic powder unit supplied from a reservoir through an opening in the wall of the cylinder, which unit has a volume equal to the volume of the plastic to be injected. This allows a very accurate dosage of the amount of plastic for e.g. mould cavity. The plastic powder unit or pallet needs only to have a volume corresponding to the combined volume of the mould cavity and the short sprue. Due to this very small components can be encapsulated with the use of only a very small amount of plastic and this is in particular true if a mould is used which is coated with a nitride. The nitride coating as well as the special configuration of the mould as described in the copending European application 83201116.7 (EP—A—101631) allows the encapsulation with good results of extremely small components.

The invention furthermore relates to a system for performing encapsulation in particular according to the method of the invention in which seen in the direction of movement of the lead frame or frames a device is placed behind the mould which in tact with the operation of the mould cleans the components of the lead frame by removing the sprue elements not belonging to the encapsulation. This is in particular of advantage in case each mould cavity has its own plastic supplying device so that each component is only connected to a short sprue which easily can be broken off.

In front of the mould a device can be placed, also operating in tact with the mould, for attaching the components to the lead frames.

The invention will now be explained more in detail with reference to the drawings in which:

Fig. 1 is a schematical top view, partly in cross-section, illustrating the injection method,

Fig. 2 is a schematical transversal cross-section of the mould together with an injection device, and

Fig. 3 illustrates in a schematical way the location of the injection devices between other devices.

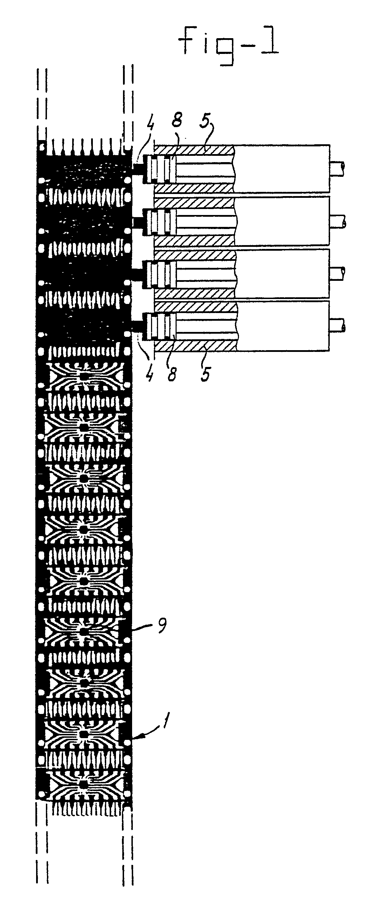

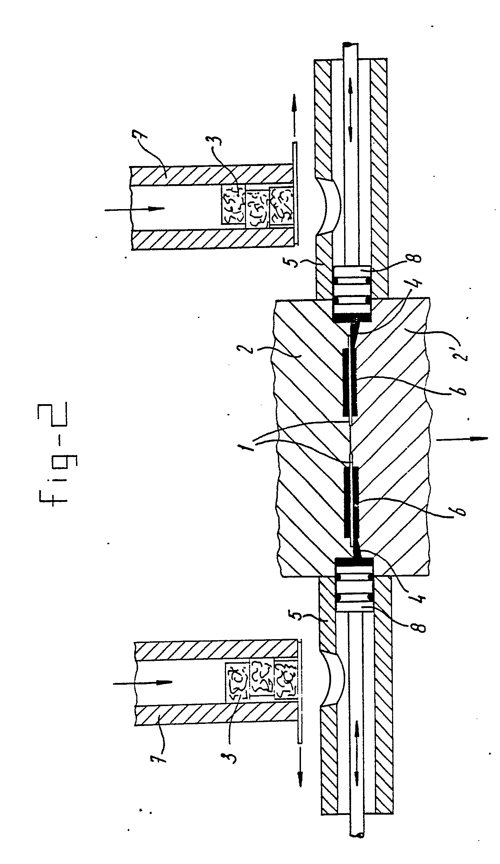

In the Figures 1 and 2 is illustrated in which way a lead frame 1 of chip carrying elements 9 is positioned in a mould 2, e.g. a mould as described in the copending European patent application 83201116.7 (EP—A—101631), whereby the connecting pins of the elements are mutually turn and turn dislocated.

The plastic material 3 is brought into the loading chamber in the form of pellets from the reservoir 7. The powder unit in the form of a pellets 3, delivered by the reservoir 7 is fluidized in the cylinder, because the adjoining mould parts 2 and 2' are heated whereafter the plastic material through the sprues 4 is injected into the mould cavities 6, in which mould cavities 6 the components of the lead frame 1 are positioned. As the stroke of the piston 8 is adjustable the injected amount of plastic encapsulating each component can be adjusted. After hardening of the plastic and releasing from the mould cavities electronic components are obtained connected to sprues with a small lump of plastic formed in a cylinder space inside the mould but outside the cylinder 5.

Said sprues have minimum dimensions and comprise a minimum amount of material. It is always necessary to have sprues because of changes in the grain size of the plastic powder, so that the volume of each pallet cannot be determined with great accuracy. With the described method, however, one obtains the result that the dosage is more accurate than with the usual central injection system, resulting into a decreased waste of plastic.

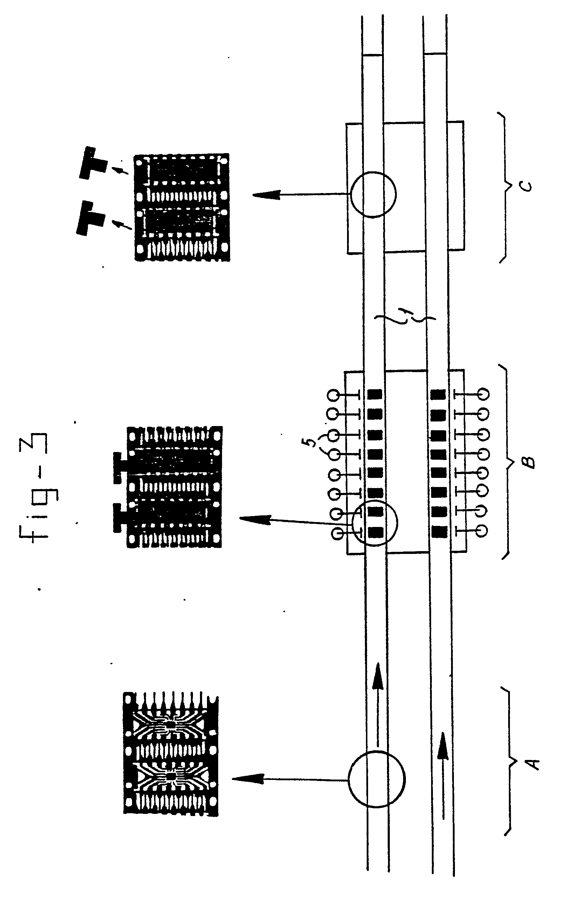

The mould has several cavities with a length corresponding substantially to the length of an element 9. Each mould cavity has its own injection cylinder 5, also schematically indicated in Fig. 3 with the reference number 5.

In Fig. 3 some devices in the neighbourhood of the injection mould are illustrated. The chips or crystals and the connecting pins are mounted onto the lead frame at A. The lead frame may be received from a supply reel and transported to the area A, in which also bonding takes place, whereafter the lead frame is transported into the described mould at B for encapsulation with plastic. Thereafter the elements, encapsulated in the mould B, can be cleaned from superfluous plastic and sprues in the device C. As a result of the method according to the invention the encapsulation in plastic can take place continuously intermittent without the necessity to cut the strip into sections. Also the supply of elements and the removal of the superfluous plastic can be carried out in a continuous (intermittent) way, so that an automized production can be realized.

## Claims

1. Method for encapsulating electronic components in a plastic material, which components are mounted in elements (9), which elements form a part of a lead frame or lead frames (1), which are placed according to one or more parallel rows in a mould, comprising a lower and upper mould member (2,2') which members can be moved against each other and away from each other and each are provided with a row or a plurality of parallel rows of mould cavities (6), which in the closed position of the mould form the spaces into which the plastic material has to be injected to encapsulate the electronic components present therein and which in number are equal to the number of elements (9), which mould cavities are connected with sprue channels (4) in at least one of the opposite faces of the mould members (2,2'), characterized in that the lead frame or lead frames (1) have a length which is a multiplicity of the length of a row of elements fitting into a row of mould cavities (6) of the mould (2,2'), which lead frame or frames (1) are step by step treated in said mould such that each time the encapsulation of a row of components of a row of elements (9) present in the mould is completed, the lead frame or frames are moved in their longitudinal direction over a distance corresponding to the length of a lead frame that fits inside the mould, and that the supply of plastic material to the sprue channels and the therewith connected mould cavities in the closed position of the mould (2,2') takes place from a side edge or the side edges of the mould which extend parallel to the row or rows of cavities.

2. System for encapsulating electronic components in a plastic material, comprising a mould with upper and lower mould members (2,2'), which can be moved apart or upon each other and which each are provided with a row or with parallel rows of complementary mould cavities (6), which each are connected with a sprue channel (4) in at least one of the opposite cooperating faces of the mould members (2,2'), which sprue channels (4) are connected to a supply of plastic material, the mutual distance between the mould cavities of each row being such that a lead frame or lead frames (1) of elements (9) with components can be placed in said mould for simultaneous encapsulation of all components of the lead frame or frames, characterized in that all sprue channels (4) extend towards the side edge or side edges of the mould which extend parallel to the row or rows of cavities (6) and at said side edge or edges are connected to a plastic supply device (5,7,8) located at the said side edge or edges and in that the system includes means for step by step transporting a lead frame strip between the upper and lower mould members.

3. System as claimed in claim 2, characterized in that each mould cavity (6) has its own plastic supplying device (5,7,8).

4. System as claimed in claim 2 or 3, characterized in that each supplying device has a press cylinder (5) with a loading chamber, which in the retracted position of the press piston (8) of said cylinder (5) offers space to a plastic powder unit (3) supplied from a reservoir (7) through an opening in the wall of the cylinder (5), which unit (3) has a volume equal to the volume of the plastic to be injected.

5. System as claimed in claim 4, characterized in that the stroke of the piston (8) of the press cylinder (5) is adjustable.

6. System as claimed in one or more of the preceding claims 2—5, in particular for performing the method of claim 1, characterized in that in the direction of movement of the lead frame or frames (1) of elements (9) a device (C) is placed behind the mould (2,2') which device in tact with the operation of the mould cleans the component of the lead frame or frames by removing the sprue elements not belonging to the encapsulation.

**Patentansprüche**

1. Verfahren zum Einkapseln elektronischer Bauteile in Kunststoff, welche Bauteile in Elementen (9) angebracht sind, welche einen Teil eines Leitungsrahmens oder von Leitungsrahmen (1) bilden, die in ein oder mehreren parallelen Reihen in eine Form gelegt werden, die ein unteres und oberes Formteil (2, 2') aufweist, welche in Richtung aufeinander und voneinander weg bewegt werden können und die jeweils mit einer Reihe oder einer Mehrzahl von parallelen Reihen von Formhohlräumen (6) versehen sind, welche im geschlossenen Zustand der Form Räume bilden, in die der Kunststoff einzuspritzen ist, um die darin vorhandenen elektronischen Bauteile einzukapseln und die in der gleichen Anzahl wie die Anzahl der Elemente (9) vorgesehen sind, wobei die Formhohlräume mit Eingußkanälen (4) wenigstens in einer der gegenüberliegenden Flächen der Formteile (2, 2') verbunden sind, dadurch gekennzeichnet, daß der Leitungsrahmen oder die Leitungsrahmen (1) eine Länge haben, die ein Vielfaches der Länge einer Reihe von in einer Reihe von Formhohlräumen (6) der Form (2, 2') vorgesehenen Elementen beträgt, daß der Leitungsrahmen oder die Leitungsrahmen (1) schrittweise in der Form derart behandelt werden, daß jedesmal wenn die Einkapselung einer Reihe von Bauteilen einer Reihe von in der Form vorhandenen Elementen (9) beendet ist, der oder die Leitungsrahmen in ihrer Längsrichtung um eine Strecke bewegt werden, die der Länge eines Leitungsrahmens entspricht, der sich im Inneren der Form befindet, und daß die Zufuhr des Kunststoffs zu den Eingußkanälen und den damit verbundenen Formhohlräumen im geschlossenen Zustand der Form (2, 2') von einem Seitenrand oder den Seitenrändern der Form erfolgt, die parallel zu der Reihe oder den Reihen von Hohlräumen verläuft oder verlaufen.

2. System zum Einkapseln elektronischer Bauteile in Kunststoff, das eine Form mit oberen und unteren Formteilen (2, 2') aufweist, die in Richtung aufeinander zu und voneinander weg bewegt werden können und die jeweils mit einer Reihe oder mit parallelen Reihen von komplementären Formhohlräumen (6) versehen sind, die jeweils mit einem Eingußkanal (4) in wenigstens einer der gegenüberliegenden zusammenarbeitenden Flächen der Formteile (2, 2') verbunden sind, wobei die Eingußkanäle (4) mit einer Zufuhr für Kunststoff verbunden sind, und wobei der wechselseitige Abstand zwischen den Formhohlräumen jeder Reihe derart ist, daß ein oder mehrere Leitungsrahmen (1) der Elemente (9) mit den Bauteilen in die Form zum gleichzeitigen Einkapseln aller Bauteile des Leitungsrahmens oder der Leitungsrahmen eingebracht werden können, dadurch gekennzeichnet, daß alle Eingußkanäle (4) sich zu dem Seitenrand oder den Seitenrändern der Form erstrecken, die parallel zu der Reihe oder den Reihen von Hohlräumen (6) verlaufen, und daß sie an diesem Seitenrand oder diesen Seitenrändern mit einer Kunststoffzufuhreinrichtung (5, 7, 8) verbunden sind, die sich an dem Seitenrand oder den Seitenrändern befindet, und daß das System Einrichtungen enthält, welche einen Leitungsrahmenstreifen zwischen den oberen und unteren Formteilen schrittweise transportieren.

3. System nach Anspruch 2, dadurch gekennzeichnet, daß jeder Formhohlraum (6) seine eigene Kunststoffzufuhreinrichtung (5, 7, 8) hat.

4. System nach Anspruch 2 oder 3, dadurch gekennzeichnet, daß jede Zufuhreinrichtung einen Preßzylinder (5) mit einer Beschickungskammer hat, welche in der eingefahrenen Stellung des Preßkolbens (8) des Zylinders (5) einen Raum für eine Kunststoffpulvereinheit (3) schafft, die von einem Vorrat (7) über eine Öffnung in der Wand des Zylinders (5) zugeführt wird, wobei die Einheit (3) ein Volumen hat, das gleich dem Volumen des einzuspritzenden Kunststoffs ist.

5. System nach Anspruch 4, dadurch gekennzeichnet, daß der Hub des Kolbens (8) des Preßzylinders (5) veränderbar ist.

6. System nach einem oder mehreren der vorangehenden Ansprüche 2 bis 5, insbesondere zur Durchführung des Verfahrens nach Anspruch 1, dadurch gekennzeichnet, daß in Bewegungsrichtung des Leitungsrahmens oder der Leitungsrahmen (1) der Elemente (9) eine Einrichtung (C) hinter der Form (2, 2') vorgesehen ist, welche im Takt mit dem Arbeiten der Form das Bauteil des Leitungsrahmens oder der Leitungsrahmen reinigt, indem die nicht zur Einkapselung gehörenden Angußteile entfernt werden.

**Revendications**

1. Procédé pour encapsuler des composants électroniques dans une matière plastique, lesquels composants sont montés dans des éléments (9) qui font partie d'un ou de cadres de montage (1) qui sont placés suivant une ou plusieurs rangées parallèles dans un moule comprenant un élément inférieur et un élément supérieur de moule (2,2'), lesquels éléments peuvent être rapprochés et écartés l'un de l'autre et sont munis chacun d'une rangée ou d'une pluralité de rangées parallèles de cavités de moule (6), qui, lorsque le moule est dans la position fermée, forment des espaces à l'intérieur desquels la matière plastique doit être injectée de manière à réaliser l'encapsulage des composants électroniques qui sont présents dans ces espaces, et qui sont en nombre égal au nombre d'éléments (9), les cavités du moule étant raccordées à des rigoles d'alimentation (4) dans au moins l'une des faces opposées des éléments de moule (2,2'), caractérisé en ce que le ou les cadres de montage (1) possèdent une longueur qui est égale à un multiple de la longueur d'une rangée d'éléments s'adaptant dans une rangée des cavités (6) du moule (2,2'), le ou les cadres de montage (1) étant traités pas-à-pas dans ledit moule de telle sorte que chaque fois que l'encapsulage d'une rangée de composants d'une rangée d'éléments (9) présents dans le moule est achevée, le ou les cadres de montage sont déplacés dans leur direction longitudinale sur une distance correspondant à la longueur d'un cadre de montage qui s'adapte à l'intérieur du moule, et que l'alimentation de matière plastique aux rigoles d'alimentation et aux cavités du moule raccordées par l'intermédiaire de ces rigoles s'effectue, lorsque le moule (2,2') est en position fermée, à partir d'un bord latéral ou des bords latéraux du moule, qui s'étendent parallèlement à la ou aux rangées de cavités.

2. Système pour encapsuler des composants électroniques dans une matière plastique, comprenant un moule possédant un élément supérieur et un élément inférieur de moule (2,2') qui peuvent être écartés ou rapprochés l'un de l'autre et qui sont munis d'une rangée ou de rangées parallèles de cavités complémentaires (6) du moule, qui sont raccordées chacune à une rigole d'alimentation (4) dans au moins l'une des faces coopérantes opposées des éléments de moule (2,2'), lesquelles rigoles d'alimentation (4) sont raccordées à une source d'alimentation de matière plastique, la distance réciproque entre les cavités du moule dans chaque rangée étant telle qu'un ou plusieurs cadres de montage (1) d'éléments (9) munis de composants peuvent être placés dans ledit moule de manière à réaliser l'encapsulage simultané de tous les composants du ou des cadres de montage, caractérisé en ce que toutes les rigoles d'alimentation (4) s'étendent en direction du ou des bords latéraux du moule, qui s'étendent parallèlement à la ou aux rangées de cavités (6) et sont raccordées au niveau du ou desdits bords latéraux, à un dispositif (5,7,8) d'alimentation de matière plastique, situé sur le ou lesdits bords latéraux, et en ce que le système comporte des moyens pour entraîner pas-à-pas une bande de cadres de montage entre les éléments supérieur et inférieur du moule.

3. Système selon la revendication 2, caractérisé en ce que chaque cavité (6) du moule possède son propre dispositif (5,7,8) d'alimentation de matière plastique.

4. Système selon la revendication 2 ou 3, caractérisé en ce que chaque dispositif d'alimentation comporte un vérin de compression (5) muni d'une chambre de charge qui, lorsque le piston de compression (8) dudit vérin (5) est en position rétractée, constitue un espace pour une unité de poudre de matière plastique (3), amenée à partir d'un réservoir (7) par l'intermédiaire d'une ouverture ménagée dans la paroi du vérin (5), laquelle unité (3) possède un volume égal au volume de matière plastique devant être injectée.

5. Système selon la revendication 4, caractérisé en ce que la course du piston (8) du vérin de compression (5) est réglable.

6. Système selon l'une ou plusieurs des revendications précédentes 2—5, en particulier pour la mise en oeuvre du procédé de la revendication 1, caractérisé en ce que, dans la direction du mouvement du ou des cadres de montage (1) des éléments (9), un dispositif (C) est disposé en arrière du moule (2,2'), ce dispositif nettoyant en cadence avec le fonctionnement du moule, le composant du ou des cadres de montage en retirant les éléments de carotte, qui n'appartiennent pas à l'élément d'encapsulage.

fig-1

Fig-2

0 101 630

Fig-3

0 101 630